# EUROPÄISCHE PATENTANMELDUNG

(11) **EP 1 703 522 A1**
(43) Veröffentlichungstag der Anmeldung: **20.09.2006**
(21) Anmeldenummer: 06004440.1
(22) Anmeldetag: 03.03.2006
(51) Int. Cl.: G11C 16/16, G11C 16/34

(54) **Verfahren zum Betrieb eines Flash-Speicherbauelementes**

(30) Priorität: 15.03.2005 US 81085
(71) Anmelder: Infineon Technologies Flash GmbH & Co. KG., 01099 Dresden (DE)
(72) Erfinder: Kern, Thomas, 81737 München (DE)
(74) Vertreter: Epping - Hermann - Fischer

(57) **Zusammenfassung**

Ein Fehlerkorrekturcode wird angewandt und eine Löschprozedur wird als erfolgreich akzeptiert, wenn eine maximale Anzahl von Einzelbitausfällen entsprechend einem Kriterium des Fehlerkorrekturcodes nicht überschritten wird.

## Beschreibung

Die vorliegende Erfindung betrifft die Löschprozedur eines Flash-Speicherbauelementes, bei der Blöcke, Seiten oder beliebig andere Bitcluster gleichzeitig gelöscht werden.

Nichtflüchtige Speicherbauelemente, die elektrisch programmierbar und löschbar sind, können als Flash-Speicherbauelemente realisiert werden, bei denen Speicherzellen einzeln programmiert, aber in Blöcken oder Seiten gelöscht werden. Eine Art von Flash-Speicher umfasst Charge-trapping-Speicherzellen mit einer Speicherschichtfolge dielektrischer Materialien, wobei eine Speicherschicht zwischen Eingrenzungsschichten aus einem dielektrischen Material angeordnet ist, das einen größeren Energiebandabstand als das Material der Speicherschicht aufweist. Die Speicherschichtfolge befindet sich an einer Oberfläche eines Halbleiterkörpers zwischen einem Kanalbereich aus Halbleitermaterial und einer Gate-Elektrode, die zur Steuerung des Kanals mittels einer angelegten elektrischen Spannung vorgesehen ist. Beispiele für Charge-trapping-Speicherzellen sind die SONOS-Speicherzellen, bei denen jede Eingrenzungsschicht ein Oxid und die Speicherschicht ein Nitrid des Halbleitermaterials (gewöhnlich Silicium) ist (US 5,768,192, US 6,011,725).

In Flash-Speicherbauelementen werden Blöcke oder Seiten gleichzeitig gelöscht. Das heißt, dass keine einzelnen Bits individuell gelöscht werden, sondern eine bestimmte Anzahl von Speicherzellen auf einmal adressiert wird, wenn eine Löschung durchgeführt wird. Da ein umfassendes und vollständiges Löschen aller relevanten Speicherzellen nicht garantiert werden kann, folgt der Löschung gewöhnlich ein Verifikationsschritt, bei dem Einzelbitausfälle erkannt werden, und die Löschprozedur wird erforderlichenfalls so lange wiederholt, bis die Löschung aller relevanten Bits verifiziert ist. Die Wiederholung der Löschprozedur kann mit erhöhten Spannungen oder gewissen anderen Modifikationen der Betriebsparameter bewirkt werden, um sicherzustellen, dass letztendlich eine vollständige Löschung erhalten wird. Dies hat den Nachteil, dass es zu einer Überlöschung (Overerase) kommen kann, die zu einer Abnahme der Lebensdauer und Datenhaltefähigkeit der Speicherzellen führt. Die Wiederholung der Löschprozedur bewirkt eine Zunahme der Löschzeiten und daher schlechte Betriebseigenschaften beim Schreiben.

Aufgabe der vorliegenden Erfindung ist die Angabe eines Verfahrens zum Betrieb eines Flash-Speicherbauelementes, das die Lösch- und Schreibprozeduren beschleunigt sowie eine ausreichende Löschung ohne Auftreten von Overerase bei hoher Lebensdauer und ausreichendem Datenerhalt sicherstellt.

Diese Aufgabe wird mit dem Verfahren mit den Merkmalen des Anspruches 1 gelöst. Ausgestaltungen ergeben sich aus den abhängigen Ansprüchen.

Dieses Verfahren zum Betrieb eines Flash-Speicherbauelementes verwendet einen Fehlerkorrekturcode (ECC) auch in der Löschprozedur. Eine Anzahl in einer Löschprozedur auftretender Einzelbitausfälle wird für jede gleichzeitig gelöschte Gruppe von Speicherzellen, wie zum Beispiel für jeden Block oder jede Seite der Speicherzellenmatrix des Bauelements, erkannt und aufgezeichnet. Die Löschprozedur ist erfolgreich abgeschlossen erledigt, wenn die Anzahl von Einzelbitausfällen einem Kriterium des Fehlerkorrekturcodes genügt. Andernfalls wird ein erneutes Löschen bewirkt, bis eine Löschung erzielt ist, die entsprechend den durch die Anwendung des Fehlerkorrekturcodes definierten Bedingungen vollständig genug ist. Zum Beispiel kann das Kriterium darin bestehen, dass die Summe aller Anzahlen von Einzelbitfehlern in der gelöschten Gruppe eine gegebene tolerierbare maximale Gesamtzahl von Ausfällen nicht übersteigt. Statt dessen kann eine Löschprozedur als erfolgreich abgeschlossen werden, wenn höchstens eine feste Anzahl von Einzelbitfehlern (zum Beispiel fünf) oder eine variable Anzahl von Einzelbitfehlern, die durch den Fehlerkorrekturcode spezifiziert wird, in jeder gelöschten Gruppe verifiziert wird. Vorzugsweise wird der Fehlerkorrekturcode auch vorgesehen, um Informationsbits bei Lese- und Schreiboperationen entsprechend dem Standardbetrieb von Fehlerkorrekturcodes zu korrigieren. Eine vorgesehene Fehlerkorrekturcodeschaltung kann also teilweise der speziellen Anwendung gemäß der vorliegenden Erfindung dienen und teilweise auf die übliche Weise angewandt werden, um Bits der gespeicherten Informationen zu korrigieren.

Es folgt eine genauere Beschreibung von Beispielen des Verfahrens anhand der beigefügten Figuren.

Die Figur 1 zeigt ein Flussdiagramm mit Schritten eines Ausführungsbeispiels des erfindungsgemäßen Verfahrens.

Die Figur 2 zeigt ein Blockdiagramm eines mit dem Verfahren betriebenen Speicherbauelementes.

Das Verfahren lässt Einzelbitausfälle bei der Verifikation der Löschprozedur zu. Dies wird durch Anwendung eines Fehlerkorrekturcodes möglich, der auch bei der Löschprozedur verfügbar ist und vorzugsweise die Korrektur von bis zu fünf Bits pro Block oder Seite abdeckt. Auf der Basis dieses Fehlerkorrekturcodes kann die Löschprozedur auch dann als abgeschlossen akzeptiert werden, wenn das Kriterium einer vollständigen Löschung nicht erfüllt ist. Die Bits, die eine längere Zeit zum Löschen beanspruchen, können vernachlässigt werden, und die Löschzeit kann verringert werden. Abhängig von der Zellenabweichung kann diese Verbesserung sehr wichtig sein. Ferner verringert die Reduktion der Löschzeit außerdem die Belastung der bereits ausreichend gelöschten Speicherzellen und vermeidet, dass diese Zellen in einen übergelöschten Zustand gezwungen werden. Die Vermeidung des Overerase erhöht die Anzahl möglicher Schreibzyklen wesentlich und verbessert außerdem den Datenerhalt nach dem Lösch-/Schreibzyklus. Der Fehlerkorrekturcode kann vollständig oder nur teilweise angewendet werden, um ausreichend Kapazität für die gewöhnlichen Programmieroperationen zu lassen. Er funktioniert bei der Löschprozedur grundsätzlich auf dieselbe Weise wie bei den gewöhnlichen Schreib- und Leseoperationen, bei denen man mit dem Fehlerkorrekturcode verfälschte Bits der gespeicherten Informationen korrigiert oder rekonstruiert.

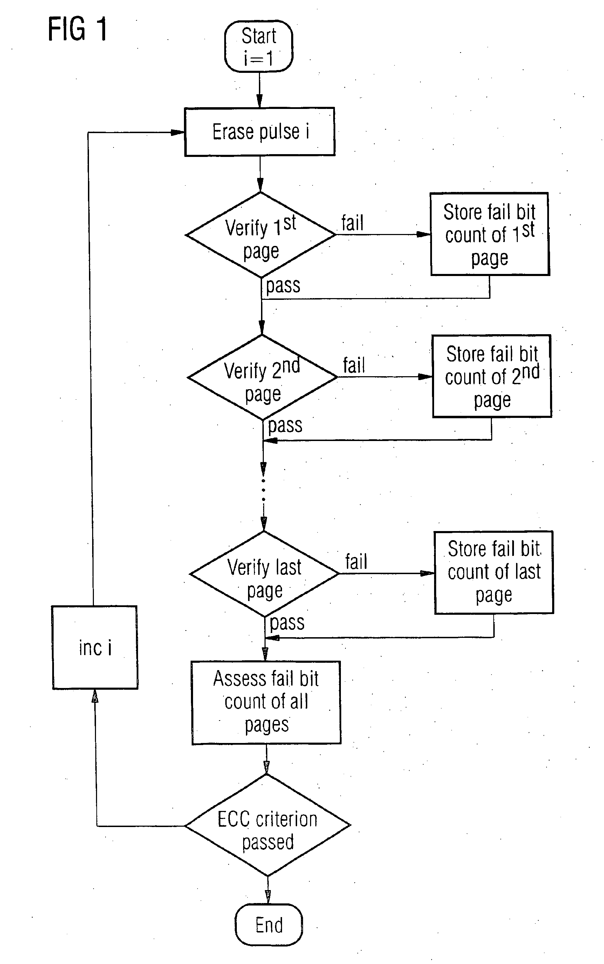

Das Flussdiagramm der Figur 1 zeigt die Schritte eines bevorzugten Beispiels für das Verfahren gemäß der vorliegenden Erfindung. Die Löschung beginnt mit dem Anlegen eines ersten Löschimpulses. Das Ergebnis der Löschung wird dann für den ersten und die folgenden Blöcke oder Seiten der Reihe nach verifiziert. Die Anzahl von Einzelbitfehlern wird für jeden Block oder jede Seite aufgezeichnet und gespeichert. Es findet eine letzte Bewertung statt, bei der eine Gesamtzahl der Anzahlen von Einzelbitausfällen ausgewertet und mit zuvor definierten Kriterien des Fehlerkorrekturcodes verglichen wird. Wenn die Kriterien erfüllt sind, gilt die Löschprozedur als erfolgreich abgeschlossen. Im entgegengesetzten Fall wird die Anzahl des Löschimpulses um 1 erhöht und die vorgeschriebene Sequenz von Programmschritten wiederholt. Jede Wiederholung kann mit einer Zunahme der angelegten Löschspannung oder mit anderen Anpassungen der Löschparameter, die für eine gründliche Löschung vorteilhaft sind, durchgeführt werden. Dadurch wird sichergestellt, dass genügend Bits korrekt gelöscht werden, so dass das Kriterium des Fehlerkorrekturcodes erfüllt wird. Wenn dies der Fall ist, wird die Löschprozedur als vollständig erfolgreich betrachtet, und der Fehlerkorrekturcode wird angewandt, um etwaige Abweichungen der tatsächlichen Zustände der gelöschten Speicherzellen von dem Zustand der Löschung zu korrigieren.

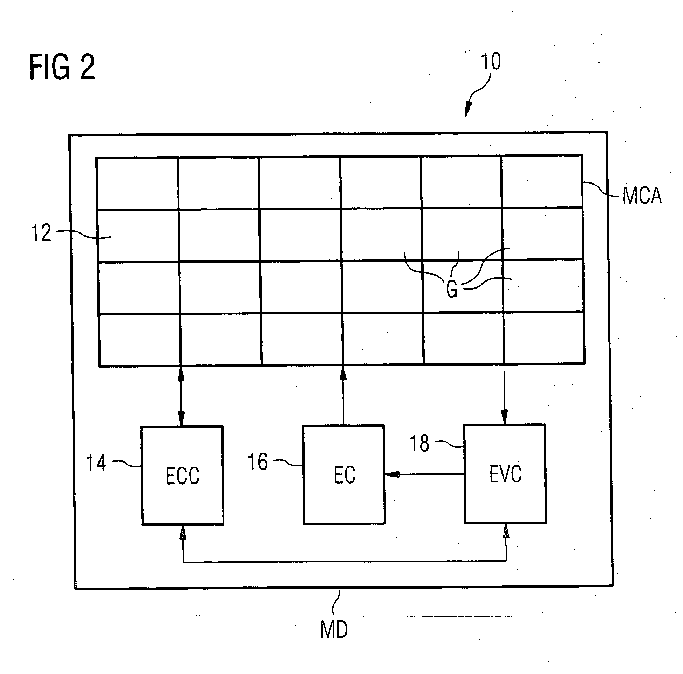

Die Figur 2 zeigt ein Blockdiagramm eines Speicherbauelementes 10 entsprechend gegenständlichen Realisationen der Erfindung. Ein Speicherzellenarray 12 (MCA) umfasst eine Vielzahl von Gruppen G von Flash-Speicherzellen. Die Gruppen können entsprechend strukturellen Sonderheiten der Anordnung gebildet sein. Statt dessen kann die Unterteilung des Speicherzellenarrays in Gruppen nicht in der Bauelementestruktur realisiert sein, sondern nur in der Ansteuerschaltung. Eine Fehlerkorrekturschaltung 14 (ECC) ist mit dem Speicherzellenarray 12 verbunden. Die Fehlerkorrekturschaltung 14 kann eingesetzt werden, um Fehler beim Lesen von Daten aus dem Speicherzellenarray festzustellen und zu korrigieren. An das Speicherzellenarray 12 ist außerdem eine Löschschaltung 16 (EC) angeschlossen, die eingesetzt werden kann, um zu bewirken, dass sich eine Löschprozedur auf alle Flash-Speicherzellen einer ausgewählten Gruppe auswirkt.

Eine Löschkontrollschaltung 18 (EVC) ist auch an das Speicherzellenarray 12 sowie außerdem an die Löschschaltung 16 und an die Fehlerkorrekturschaltung 14 angeschlossen. Die Löschkontrollschaltung 18 kann eingesetzt werden, um Daten aus Flash-Speicherzellen der ausgewählten Gruppe auszulesen, nachdem eine Löschprozedur stattgefunden hat. Die Löschkontrollschaltung 18 detektiert eine Anzahl von Einzelbitausfällen und bestimmt, ob der Löschvorgang wiederholt werden muss. Der Löschvorgang wird wiederholt, falls die Anzahl von Einzelbitausfällen ein Kriterium nicht erfüllt. Wie zuvor beschrieben, ist das Kriterium auf der Grundlage einer Anzahl von Ausfällen, die durch die Fehlerkorrekturschaltung 14 ausgeglichen werden können, bestimmt.

Obwohl die vorliegende Erfindung und ihre Vorteile ausführlich beschrieben wurden, versteht sich, das verschiedene Änderungen, Substitutionen und Modifikationen daran vorgenommen werden können, ohne von dem Gedanken und Schutzumfang der Erfindung abzuweichen, der durch die angefügten Ansprüche definiert wird.

### Bezugszeichenliste

- 10: Speicherbauelement
- 12: Speicherzellenarray
- 14: Fehlerkorrekturschaltung
- 16: Löschschaltung
- 18: Löschkontrollschaltung

## Patentansprüche

1. Verfahren zum Betrieb eines Flash-Speicherbauelementes, bei dem
ein Fehlerkorrekturcode angewendet wird,
eine Speicherzellenmatrix (12) in Gruppen von Speicherzellen eingeteilt wird, die jeweils gleichzeitig gelöscht werden,
eine Anzahl von Einzelbitausfällen in einem Löschvorgang für jede gelöschte Gruppe erfasst und gespeichert wird,
der Löschvorgang als abgeschlossen akzeptiert wird, wenn die Anzahl von Einzelbitausfällen einem Kriterium des Fehlerkorrekturcodes entspricht, und
ein weiterer Löschvorgang erfolgt, wenn die Anzahl von Einzelbitausfällen nicht dem Kriterium des Fehlerkorrekturcodes entspricht.

2. Verfahren nach Anspruch 1, bei dem
die Anzahlen von Einzelbitausfällen summiert werden, um eine Gesamtzahl zu erhalten, und
als Kriterium des Fehlerkorrekturcodes eine tolerierbare maximale Gesamtzahl von Ausfällen verwendet wird.

3. Verfahren nach Anspruch 1 oder 2, bei dem
der Fehlerkorrekturcode auch zum Korrigieren von Informationsbits in Lese- und Schreiboperationen vorgesehen wird.

4. Verfahren nach einem der Ansprüche 1 bis 3, bei dem
ein Löschvorgang als abgeschlossen akzeptiert wird, wenn in jeder gelöschten Gruppe höchstens eine feste Anzahl von Einzelbitausfällen oder eine variable Anzahl von Einzelbitausfällen, die durch den Fehlerkorrekturcode spezifiziert wird, erfasst wird.
